# EUROPÄISCHE PATENTSCHRIFT

(11) **EP 3 167 253 B1**
(45) Veröffentlichungstag und Bekanntmachung des Hinweises auf die Patenterteilung: **20.03.2019**
(21) Anmeldenummer: 15732631.5
(22) Anmeldetag: 25.06.2015
(51) Int. Cl.: G01D 11/10, G01D 11/30

(54) **KÖRPERSCHALLENTKOPPLUNG AN MIT GEBERFELDERN ARBEITENDEN SENSOREN**
VIBRATION DECOUPLING OF SENSORS
DÉCOUPLAGE DE VIBRATION DE CAPTEURS

(30) Priorität: 08.07.2014 DE 102014213217
(43) Veröffentlichungstag der Anmeldung: 17.05.2017
(73) Patentinhaber: Continental Teves AG & Co. OHG, 60488 Frankfurt am Main (DE)
(72) Erfinder: FISCHER, Thomas, 65931 Frankfurt am Main (DE); SCHILLINGER, Jakob, 85080 Gaimersheim (DE); HUBER, Dietmar, 63322 Rödermark (DE); GÜNTHNER, Stefan, 60439 Frankfurt am Main (DE); BIEBRICHER, Lothar, 61440 Oberursel (DE); SCHULMEISTER, Michael, 64846 Groß-Zimmern (DE)
(86) Internationale Anmeldenummer: PCT/EP2015/064419
(87) Internationale Veröffentlichungsnummer: WO 2016/005202

(56) Entgegenhaltungen:
- DE-A1-102007 017 641
- DE-A1-102010 000 848
- DE-A1-102012 201 486
- DE-A1-102012 223 982
- US-A- 5 223 738

## Beschreibung

Die Erfindung betrifft einen Sensor zum Erfassen eines von einer zu messenden physikalischen Größe abhängigen physikalischen Geberfeldes.

Aus der WO 2010 / 037 810 A1 ist ein Sensor mit einer Sensorschaltung bekannt, die eingerichtet ist, über ein von einer zu messenden physikalischen Größe abhängiges physikalisches Geberfeld ein von der zu messenden physikalischen Größe abhängiges Sensorsignal auszugeben.

Die Druckschrift DE 10 2012 201486 A1 beschreibt eine Dämpfungsvorrichtung für eine mikromechanische Sensoreinrichtung, aufweisend wenigstens eine erste Zwischenlageneinrichtung mit wenigstens zwei Abschnitten, wobei ein zweiter Abschnitt um einen ersten Abschnitt herum angeordnet ist, wobei ein lateraler Abstand zwischen dem ersten und dem zweiten Abschnitt ausgebildet ist, wobei eine federnde Einrichtung als integraler Teil der ersten Zwischenlageneinrichtung zwischen dem ersten Abschnitt und dem zweiten Abschnitt ausgebildet ist.

Die DE 10 2010 000848 A1 offenbart ein Trägermaterial mit einer mechanischen Filtereigenschaft, das zumindest einen Haltebereich zur Halterung des Trägermaterials aufweist. Ferner weist das Trägermaterial einen Sensorbereich mit Sensoranschlusskontakten auf. Weiterhin umfasst das Trägermaterial einen mit dem zumindest einen Haltebereich und dem Sensorbereich gekoppelten Trennbereich, der zwischen dem zumindest einen Haltebereich und dem Sensorbereich angeordnet ist. Dabei weist das Trägermaterial in dem Trennbereich zur Ausbildung einer mechanischen Filtereigenschaft eine andere Struktur auf, als das Trägermaterial in dem Haltebereich und/oder in dem Sensorbereich.

Die DE 10 2007 017641 A1 offenbart ein Halbleiterprodukt beinhaltend ein Substrat, ein auf das Substrat aufgebrachten Halbleiterchip, und eine an den Halbleiterchip angrenzende Schicht, wobei in der Schicht beschichtete Partikel enthalten sind, und wobei die beschichteten Partikel einen ferromagnetischen, ferrimagnetischen oder paramagnetischen Kern und eine Beschichtung haben.

Es ist Aufgabe der Erfindung, den diesen Sensor zu verbessern.

Die Aufgabe wird durch die Merkmale der unabhängigen Ansprüche gelöst. Bevorzugte Weiterbildungen sind Gegenstand der abhängigen Ansprüche.

Gemäß einem Aspekt der Erfindung umfasst ein Sensor zum Erfassen eines von einer zu messenden physikalischen Größe abhängigen physikalischen Geberfeldes eine Sensorschaltung zum Erfassen des Geberfeldes und zum Ausgeben eines vom Geberfeld abhängigen Sensorsignals, einen Schaltungsträger mit einem ersten Bereich in dem wenigstens ein Teil der Sensorschaltung getragen ist und einem zweiten Bereich, in dem wenigstens eine ersten mechanischen Schnittstelle und eine zweiten mechanischen Schnittstelle zum Anbinden des Schaltungsträgers an einen Halter angeordnet ist, und ein zwischen dem ersten Bereich und dem zweiten Bereich angeordnetes Schallwiderstandselement, das eingerichtet ist, über die erste mechanische Schnittstelle eintretenden Körperschall zur zweiten mechanischen Schnittstelle zu leiten.

Dem angegebenen Sensor liegt die Überlegung zugrunde, dass Sensoren, wie der angegebene Sensoren in der Regel in Umgebungen eingesetzt werden, in denen Körperschall-Schwingungen aufgrund von anderen elektrischen Komponenten, wie beispielsweise

Die DE 10 2007 017641 A1 offenbart ein Halbleiterprodukt beinhaltend ein Substrat, ein auf das Substrat aufgebrachten Halbleiterchip, und eine an den Halbleiterchip angrenzende Schicht, wobei in der Schicht beschichtete Partikel enthalten sind, und wobei die beschichteten Partikel einen ferromagnetischen, ferrimagnetischen oder paramagnetischen Kern und eine Beschichtung haben.

Es ist Aufgabe der Erfindung, den diesen Sensor zu verbessern.

Die Aufgabe wird durch die Merkmale der unabhängigen Ansprüche gelöst. Bevorzugte Weiterbildungen sind Gegenstand der abhängigen Ansprüche.

Gemäß einem Aspekt der Erfindung umfasst ein Sensor zum Erfassen eines von einer zu messenden physikalischen Größe abhängigen physikalischen Geberfeldes eine Sensorschaltung zum Erfassen des Geberfeldes und zum Ausgeben eines vom Geberfeld abhängigen Sensorsignals, einen Schaltungsträger mit einem ersten Bereich in dem wenigstens ein Teil der Sensorschaltung getragen ist und einem zweiten Bereich, in dem wenigstens eine ersten mechanischen Schnittstelle und eine zweiten mechanischen Schnittstelle zum Anbinden des Schaltungsträgers an einen Halter angeordnet ist, und ein zwischen dem ersten Bereich und dem zweiten Bereich angeordnetes Schallwiderstandselement, das eingerichtet ist, über die erste mechanische Schnittstelle eintretenden Körperschall zur zweiten mechanischen Schnittstelle zu leiten. Der Schaltungsträger ist als Leadframe und das Schallwiderstandselement ist als Schlitz in dem Leadframe ausgebildet. Der Sensor umfasst ein mechanisches Entkopplungselement, das den ersten Bereich des Schaltungsträgers, die Sensorschaltung und wenigstens teilweise das, vorzugsweise als der zuvor genannte Schlitz ausgebildete, Schallwiderstandselement einhüllt.

Dem angegebenen Sensor liegt die Überlegung zugrunde, dass Sensoren, wie der angegebene Sensoren in der Regel in Umgebungen eingesetzt werden, in denen Körperschall-Schwingungen aufgrund von anderen elektrischen Komponenten, wie beispielsweise Kondensatoren oder anderen mechanischen Komponenten, wie beispielsweise Aktoren auftreten. Diese Körperschallschwingungen können die Sensorschaltung bewegen und so neben dem eigentlichen physikalischen Geberfeld ebenfalls das Sensorsignal beeinflussen und damit die Messung der zu messenden physikalischen Größe verfälschen. Dies kann insbesondere bei Inertialsensoren beobachtet werden, in denen das physikalische Geberfeld die eigentlich zu messende physikalische Größe, wie beispielsweise die Beschleunigungen eines Fahrzeugs in den Raumachsen darstellt.

Hier greift der angegebene Sensor mit dem Vorschlag an, den Körperschall nicht bis zur Sensorschaltung vordringen zu lassen, sondern diesen möglichst an der Sensorschaltung vorbeizuleiten. Dies wird dadurch erreicht, dass der Sensor in zwei Bereiche aufgeteilt wird, wobei der erste Bereich die Sensorschaltung zumindest teilweise trägt, und der zweite Bereich an die Umgebung, wie beispielsweise ein Fahrzeug angebunden, in der die zu messende physikalische Größe erfasst werden soll. Ein Schallwiderstandselement zwischen diesen beiden Bereichen wirkt für den in den zweiten Bereich eintretenden Körperschall wie eine Wand, so dass sich der Körperschall getreu nach dem Prinzip, immer dem Weg mit dem geringsten Widerstand folgen, an der Wand vorbei bewegt und aus dem zweiten Bereich wieder austritt.

Daher kommt der Körperschall nicht beim Schallwiderstandselement an und kann so die Messung der zu messenden physikalischen Größe nicht beeinflussen. Im Ergebnis ist die Messung der zu messenden physikalischen Größe deutlich präziser.

Ein Leadframe ist ein Schaltungsträger, dessen Leiterbahnen aus einem blechförmigen Grundmaterial durch Trennverfahren wie Stanzen herausgeformt werden. Dabei lässt sich auch das als Schlitz ausgebildete Schallwiderstandselement im Rahmen eines Trennverfahrens, wie Stanzen herausformen, so dass das Schallwiderstandselement mit den gleichen Werkzeugen hergestellt werden kann, wie der Schaltungsträger selbst und somit keine größeren Herstellungskosten zur Realisierung des Schallwiderstandselements anfallen.

In einer besonderen Weiterbildung des angegebenen Sensors sind der Schlitz um den ersten Bereich umlaufend ausgebildet und der zweite Bereich mit dem ersten Bereich über wenigstens einen Steg verbunden. Durch den umlaufenden Schlitz wird der erste Bereich, in dem die Sensorschaltung angeordnet ist, gegenüber dem zweiten Bereich praktisch schwimmend gelagert, wobei prinzipbedingt eine vernachlässigbar kleine Schallbrücke, der wenigstens eine Steg, verbleibt, über den weiterhin Körperschall vom zweiten Bereich in den ersten Bereich eindringen kann. Diese schwimmende Lagerung dämpft dabei den in den ersten Bereich eindringenden Körperschall weiter, weil der eindringende Körperschall den ersten Bereich aufgrund seiner mechanischen Trägheit und der schwimmenden Lagerung weniger stark ins Schwingen versetzen kann.

Vorzugsweise um die schwimmende Lagerung des Körperschalles zu unterstützen, kann der angegebene Sensor in einer anderen Weiterbildung ein mechanisches Entkopplungselement umfassen, das den ersten Bereich des Schaltungsträgers, die Sensorschaltung und wenigstens teilweise das, vorzugsweise als der zuvor genannte Schlitz ausgebildete, Schallwiderstandselement einhüllt. Durch das mechanische Entkopplungselement kann die zuvor erläuterte schwimmende Lagerung weiter unterstützt werden, wobei das mechanische Entkopplungselement auch andere Schallwellen, die nicht durch Körperschall bedingt sind, dämpfen kann.

Dazu sollte das mechanische Entkopplungselement ein möglichst weiches Material sein. Im Rahmen einer zweckmäßigen Weiterbildung des angegebenen Sensors könnte das mechanische Entkopplungselement eine Silikonmasse umfassen, die besonders kostengünstig ist, jedoch alle notwendigen Anforderungen zur Schallentkopplung des zweiten Bereichs vom ersten Bereich des angegebenen Sensors erfüllt.

Um die Schallentkopplung weiter zu verbessern könnte das mechanische Entkopplungselement des angegebenen Sensors in einer besonderen Weiterbildung eine Schallentkopplungsfolie umfassen, auf der der erste Bereich des Schaltungsträgers getragen ist. Dann könnte beispielsweise die Silikonmasse auf die der Schallentkopplungsfolie gegenüberliegende Seite des Schaltungsträgers aufgespritzt werden, was sich mit hoher Präzision in einfacher Weise in Massenfertigung realisieren lässt. Dann wäre der erste Bereich des Schaltungsträgers zwischen der Silikonmasse und der Schallentkopplungsfolie wie in einem Sandwich aufgenommen.

In einer zusätzlichen Weiterbildung des angegebenen Sensors ist an wenigstens eine der beiden mechanischen Schnittstellen ein elektrisches Bezugspotential angelegt. Auf diese Weise kann die mechanische Schnittstelle, die beispielsweise über den weiter oben genannten Steg ohnehin mit dem ersten Bereich des Schaltungsträgers und damit mit der Sensorschaltung verbunden ist, auch zur Realisierung einer elektrischen Funktion verwendet werden.

Weiter kann der Sensor in einer noch weiteren Weiterbildung ein Entkopplungsbauteil, wie beispielsweise eine Schallentkopplungsfolie umfassen, die gleich oder verschieden zur zuvor genannten Schallentkopplungsfolie sein kann, umfassen. Das heißt, dass beispielsweise ein Teil der Sensorschaltung, wie beispielsweise der oder die Messaufnehmer der Sensorschaltung auf der zuvor genannten Schallentkopplungsfolie direkt getragen werden kann. Im Schaltungsträger könnte dann beispielsweise eine Ausnehmung ausgebildet sein, in der dieser Teil der Sensorschaltung dann eingesetzt ist. Auf diese Weise kann die Schallentkopplung weiter gesteigert werden.

Der angegebene Sensor kann in einer Schutzmasse beispielsweise aus Duroplast eingehaust sein, durch der angegebene Sensor weitestgehend vor Verwitterungserscheinungen geschützt werden kann.

Der angegebene Sensor kann ein Raddrehzahlsensor oder ein Inertialsensor für ein Fahrzeug sein.

Gemäß einem weiteren Aspekt der Erfindung umfasst ein Fahrzeug einen angegebenen Sensor.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
Fig. 1 eine schematische Ansicht eines Fahrzeuges mit einer Fahrdynamikregelung,
Fig. 2 einen schematische Darstellung eines Inertialsensors in dem Fahrzeug der Fig. 1,
Fig. 3 eine Ausführung des Inertialsensors der Fig. 2 in einer schematischen Schnittdarstellung,
Fig. 4 der Inertialsensors der Fig. 3 auf einer Leiterplatte in einer schematischen Seitenansicht,
Fig. 5 eine alternative Ausführung des Inertialsensors der

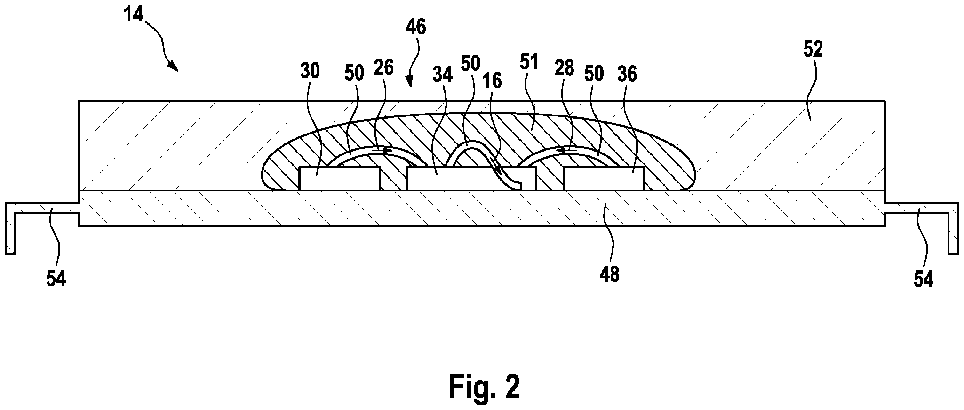

Fig. 2 in einer schematischen Schnittdarstellung,

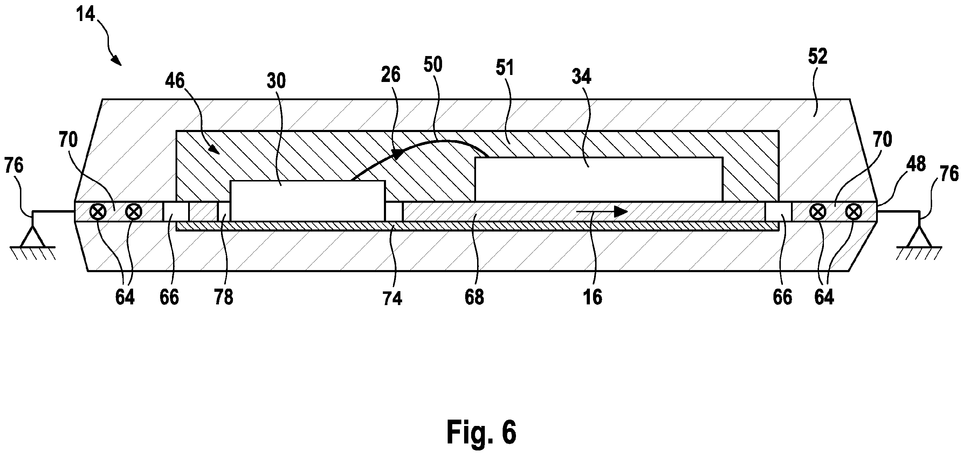

Fig. 6 eine weitere alternative Ausführung des Inertialsensors der Fig. 2 in einer schematischen Schnittdarstellung, und

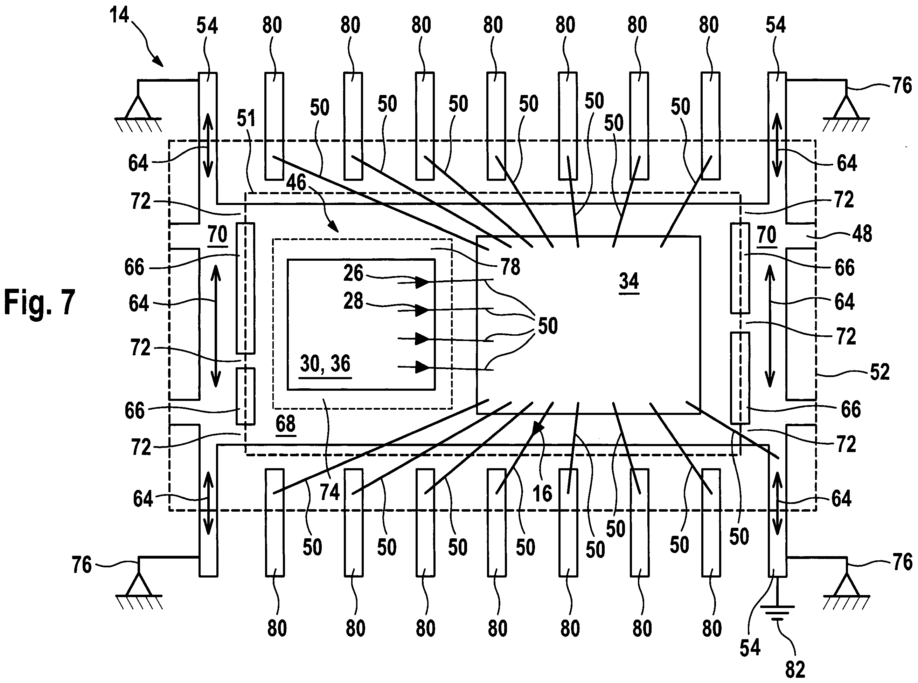

Fig. 7 eine noch weitere alternative Ausführung des Inertialsensors der Fig. 2 in einer schematischen Draufsicht zeigen.

In den Figuren werden gleiche technische Elemente mit gleichen Bezugszeichen versehen und nur einmal beschrieben.

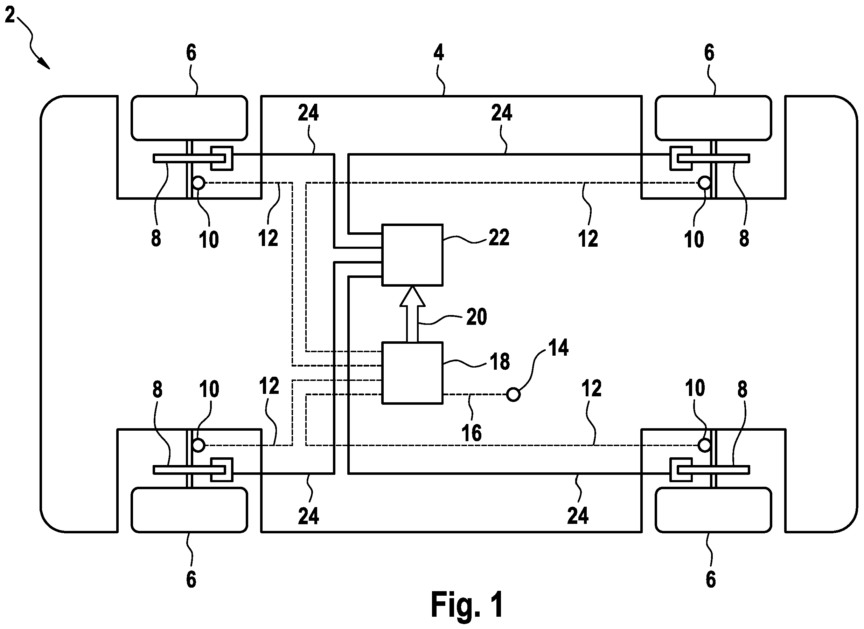

Es wird auf Fig. 1 Bezug genommen, die eine schematische Ansicht eines Fahrzeuges 2 mit einer an sich bekannten Fahrdynamikregelung zeigt. Details zu dieser Fahrdynamikregelung können beispielsweise der DE 10 2011 080 789 A1 entnommen werden.

Das Fahrzeug 2 umfasst ein Chassis 4 und vier Räder 6. Jedes Rad 6 kann über eine ortsfest am Chassis 4 befestigte Bremse 8 gegenüber dem Chassis 4 verlangsamt werden, um eine Bewegung des Fahrzeuges 2 auf einer nicht weiter dargestellten Straße zu verlangsamen.

Dabei kann es in einer dem Fachmann bekannten Weise passieren, dass das die Räder 6 des Fahrzeugs 2 ihre Bodenhaftung verlieren und sich das Fahrzeug 2 sogar von einer beispielsweise über ein nicht weiter gezeigtes Lenkrad vorgegebenen Trajektorie durch Untersteuern oder Übersteuern wegbewegt. Dies wird durch an sich bekannte Regelkreise wie ABS (Antiblockiersystem) und ESP (elektronisches Stabilitätsprogramm) vermieden.

In der vorliegenden Ausführung weist das Fahrzeug 2 dafür Drehzahlsensoren 10 an den Rädern 6 auf, die eine Drehzahl 12 der Räder 6 erfassen. Ferner weist das Fahrzeug 2 einen Inertialsensor 14 auf, der nachstehend Fahrdynamikdaten 16 genannte Inertialdaten des Fahrzeuges 2 erfasst die beispielsweise eine Nickrate, eine Wankrate, eine Gierrate, eine Querbeschleunigung, eine Längsbeschleunigung und/oder eine Vertikalbeschleunigung des Fahrzeuges 2 umfassen können.

Basierend auf den erfassten Drehzahlen 12 und Fahrdynamikdaten 16 kann ein Regler 18 in einer dem Fachmann bekannten Weise bestimmen, ob das Fahrzeug 2 auf der Fahrbahn rutscht oder sogar von der oben genannten vorgegebenen Trajektorie abweicht und entsprechen mit einem an sich bekannten Reglerausgangssignal 20 darauf reagieren. Das Reglerausgangssignal 20 kann dann von einer Stelleinrichtung 22 verwendet werden, um mittels Stellsignalen 24 Stellglieder, wie die Bremsen 8 anzusteuern, die auf das Rutschen und die Abweichung von der vorgegebenen Trajektorie in an sich bekannter Weise reagieren.

Der Regler 18 kann beispielsweise in eine an sich bekannte Motorsteuerung des Fahrzeuges 2 integriert sein. Auch können der Regler 18 und die Stelleinrichtung 22 als eine gemeinsame Regeleinrichtung ausgebildet und optional in die zuvor genannte Motorsteuerung integriert sein.

Um die nachstehenden Erklärungen zu vereinfachen soll in nicht einschränkender davon ausgegangen werden, dass der Inertialsensor 14 als Fahrdynamikdaten 16 die in Fig. 2 angedeutete Querbeschleunigung 26 auf das Fahrzeug sowie die Gierrate 28 erfasst, mit der sich das Fahrzeuges 2 um seine Hochachse dreht, weil diese im Rahmen des zuvor genannten Stabilitätsprogrammes in der Regel zum Einsatz kommen.

Zwar wird die Erfindung anhand des Inertialsensors 14 näher erläutert, jedoch kann die Erfindung auf beliebige Sensoren, wie beispielsweise die genannten Drehzahlsensoren 10 angewendet werden.

Nachstehend wird das ein mögliches Prinzip für den Inertialsensors 14 anhand von Fig. 2 näher erläutert.

Zur Erfassung der Querbeschleunigung 26 ist in dem Inertialsensor 14 ein Querbeschleunigungsmessaufnehmer 30 angeordnet. Der Querbeschleunigungsmessaufnehmer 30 ist einem physikalischen Geberfeld in Form eines Zentrifugalkraftfeldes 32 ausgesetzt, das auf den Querbeschleunigungsmessaufnehmer 30 wirkt und mit der zu erfassenden Querbeschleunigung 26 auf das Fahrzeug 2 beschleunigt. Die erfasste Querbeschleunigung 26 wird anschließend an eine Signalaufbereitungsschaltung 34 ausgegeben.

Zur Erfassung der Gierrate 28 ist in dem Inertialsensor 14 ein Coriolisbeschleunigungsmessaufnehmer 36 angeordnet. Der Coriolisbeschleunigungsmessaufnehmer 36 ist einem physikalischen Geberfeld in Form eines Corioliskraftfeldes 38 ausgesetzt. Als Antwort auf das Corioliskraftfeld 38 gibt der Coriolisbeschleunigungsmessaufnehmer 36 ein Gebersignal 40 aus, das dann in einer gegebenenfalls noch zum Coriolisbeschleunigungsmessaufnehmer 36 dazugehörenden Auswerteeinrichtung 42 in die Gierrate 28 umgerechnet werden kann. Ein Beispiel, wie die Gierrate 28 basierend auf einem Corioliskraftfeld 38 erfasst werden kann, ist in der Druckschrift DE 10 2010 002 796 A1 beschrieben, weshalb hier der Kürze halber darauf verzichtet werden soll. Auch die erfasste Gierrate 28 wird an die Signalaufbereitungsschaltung 34 ausgegeben.

In der Signalaufbereitungsschaltung 34 können die so erfasste Querbeschleunigung 26 und Gierrate 28 nachbearbeitet werden, um beispielsweise den Rauschbandabstand zu mindern und die Signalstärke zu erhöhen. Die so aufbereitete Querbeschleunigung 26 und Gierrate 28 kann dann an eine Schnittstelle 44 ausgegeben werden, die dann die beiden erfassten Signale als Fahrdynamikdaten 16 an den Regler 18 sendet. Diese Schnittstelle 44 könnte beispielsweise basierend auf dem PSI5-Standard oder dem CAN-Standard aufgebaut sein.

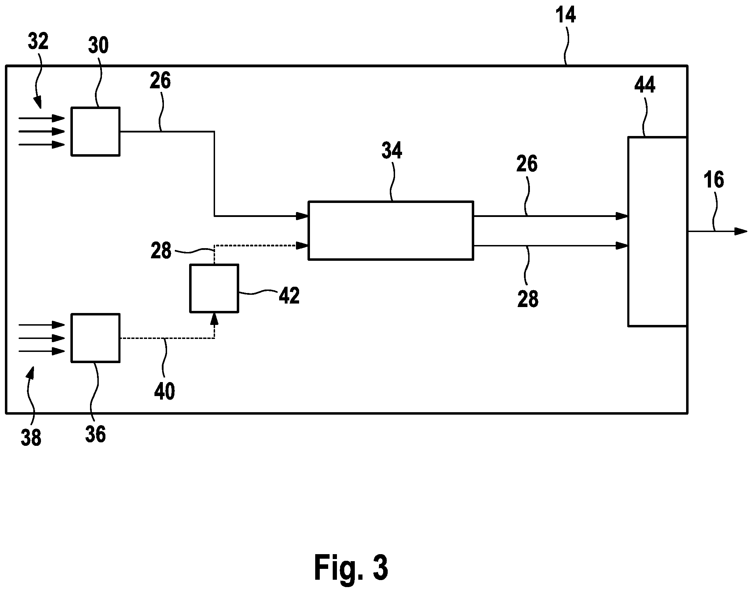

Nachstehend soll anhand der Fig. 3 eine Ausführung des Inertialsensors 14 näher erläutert werden.

Im Rahmen der vorliegenden Ausführung bilden die beiden Messaufnehmer 30, 36 und die Signalaufbereitungsschaltung 34 eine Sensorschaltung 46 aus, die auf einem als Leadframe 48 ausgeführten Schaltungsträger getragen und verschaltet ist. Gegebenenfalls nicht auf dem Leadframe 48 realisierbare Verschaltungen können hier über elektrische Leitungen in Form von Bonddrähten 50 realisiert werden. Die Schnittstelle 44 kann in die Signalaufbereitungsschaltung 34 integriert und als anwendungsspezifische integrierte Schaltung, nachstehend ASIC 34 (engl: application-specific integrated circuit) genannt, ausgebildet sein.

Die Sensorschaltung 46 kann ferner von einem mechanischen Entkopplungsmaterial 51, auch Globetop-Masse 51 genannt, in Form eines Silikonmaterials umhüllt sein, das wiederum gemeinsam in einem Spritzpressmaterial 52, wie beispielsweise einem Duroplast in Form eines Epoxidharzes 52 verkapselt sein kann. Schließlich ragen vom Inertialsensor 14 entsprechende Kontaktmöglichkeiten, wie in Fig. 2 gezeigte Beinchen 54 zur elektrischen Kontaktierung mit einem Schaltkreis wie beispielsweise des Reglers 18 ab.

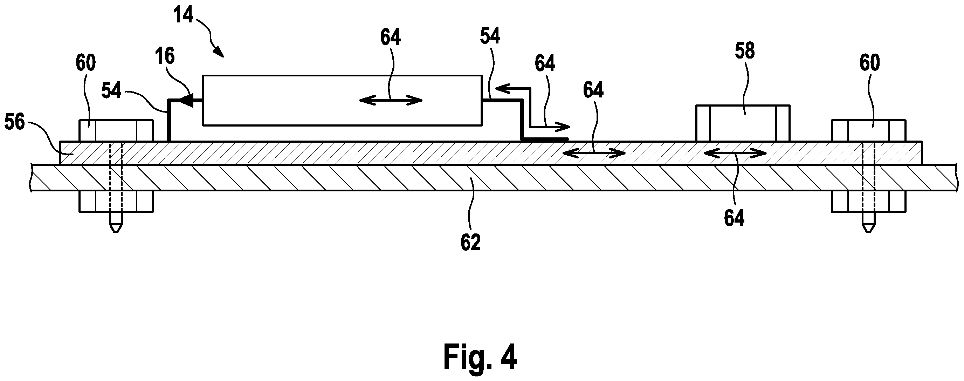

Es wird auf Fig. 4 Bezug genommen, anhand derer eine mögliche Verfälschung der Fahrdynamikdaten 16 näher erläutert werden soll.

Der die Querbeschleunigung 26 und/oder die Gierrate 28 als Fahrdynamikdaten 16 erfassende Inertialsensor 14 könnte in einem an sich bekannten Reflow-Lötprozess direkt auf eine Leiterplatte 56 gelötet werden, auf der beispielsweise auch der Regler 18 realisiert sein könnte. Auf dieser Leiterplatte 56 könnten sich zusätzlich keramische Kondensatoren 58 befinden. Zusätzlich könnte die Leiterplatte 56 über eine Anschraubbefestigung 60 mit anderen technischen Elementen in dem Fahrzeug 2, wie beispielsweise einem elektrische Ventil und/oder einem in Fig. 4 angedeuteten Gehäuse 62 verbunden sein. Es hat sich gezeigt, dass Körperschall 64, erzeugt durch geschaltete Kondensatoren, wie dem keramischen Kondensator 58 und/oder die anderen technischen Elemente, wie das zuvor erwähnte elektrische Ventil, das beispielsweise als Magnetventil ausgeführt sein kann, und/oder Karosserieschwingungen des Chassis 4 über die Leiterplatte 56 und die Beinchen 54 zum Leadframe 48 und von dort zu den Messaufnehmern 30, 36 geleitet werden kann.

Der Körperschall 64 regt die beiden Messaufnehmer 30, 36 zu Schwingungen an, die das Zentrifugalkraftfeld 32 und dem Corioliskraftfeld 38 überlagern und so die zu erfassende Querbeschleunigung 26 und/oder die zu erfassende Gierrate 28 beeinflussen können. Diese Überlagerung mit den Geberfeldern 32, 38 kann somit zu einem fehlerhaften Sensorsignal in Form der Fahrdynamikdaten 16 führen, was wiederum zu fehlerhaften Reaktionen des Reglers 18 führen kann.

Daher sollten die durch den Körperschall 64 erregten Schwingungen so weit wie möglich vermieden werden.

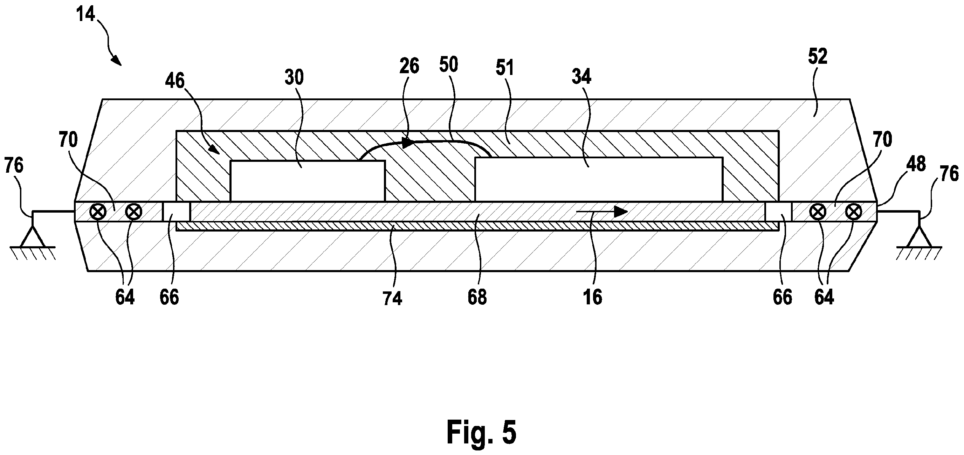

Dies soll nachstehend anhand der Fig. 5 näher erläutert werden, die den Inertialsensor 14 in einer alternativen Ausführung zeigt. Ausschließlich der Kürze und Übersichtlichkeit halber ist in Fig. 5 der Coriolisbeschleunigungsmessaufnehmer 36 weggelassen worden.

Im Rahmen des in Fig. 5 gezeigten Inertialsensors 14 sollen die durch den Körperschall 64 erregten Schwingungen mit einem Schallwiderstandselement 66 gedämpft werden. Dieses Schallwiderstandselement 66 ist als um die Sensorschaltung 46 umlaufender Schlitz 66 im Leadframe 48 ausgebildet, so dass der Leadframe 48 in einen ersten Bereich 68 und einen zweiten Bereich 70 unterteilt ist. Die beiden Bereiche 68, 70 können dabei über dünne Stege 72, wie sie beispielsweise in Fig. 7 zu sehen sind, miteinander verbunden werden.

Die Leiterplatte 48 ist unterhalb der Sensorschaltung 46 auf einer Schallentkopplungsfolie 74 gelagert, wobei sich die Schallentkopplungsfolie 74 und das Globetop-Material 51 im umlaufenden Schlitz 66 berühren können. Der zweite Bereich 70 des Leadframes 48 ist über die in Fig. 5 nicht angedeuteten Beinchen 54 fest mit der Leiterplatte 56 verbunden, was durch Festlager 76 angedeutet ist. Demgegenüber ist der erste Bereich 68 des Leadframes 48 durch den umlaufenden Schlitz 66 schwimmend gelagert, so dass er durch den Körperschall 64 nicht zum schwingen angeregt werden kann. Folglich können auch die Messaufnehmer 30, 36 nicht zum schwingen angeregt und die Fahrdynamikdaten 16 verfälscht werden.

Um die Schallentkopplung weiter zu steigern können, wie in Fig. 6 anhand des Querbeschleunigungsmessaufnehmers 30 gezeigt, die Messaufnehmer 30, 36 auf der Schallentkopplungsfolie 74 direkt angeordnet werden. Dazu kann in dem ersten Bereich 68 des Leadframes 48 eine entsprechende Ausnehmung 78 ausgebildet werden, in der der entsprechende Messaufnehmer 30, 36 dann aufgenommen werden kann.

Wie in Fig. 7 gezeigt, können die einzelnen Messaufnehmer 30, 36 in einer einzigen Messaufnehmerschaltung untergebracht werden, wobei die Signalaufbereitungsschaltung 34 die einzelnen so erfassten Fahrdynamikdaten 16 über Bonddrähte 50 an elektrische Schnittstellen 80 ausgibt. Ferner kann der Leadframe 48 beispielsweise an einem der Festlager 76 mit einem Bezugspotential 82 verbunden sein.

## Patentansprüche

1. Sensor (14) zum Erfassen eines von einer zu messenden physikalischen Größe (16) abhängigen physikalischen Geberfeldes (32, 38), umfassend:
- eine Sensorschaltung (46) zum Erfassen des Geberfeldes (32, 38) und zum Ausgeben eines vom Geberfeld (32, 38) abhängigen Sensorsignals (26, 28),
- einen Schaltungsträger (48) mit einem ersten Bereich (68) in dem wenigstens ein Teil (34) der Sensorschaltung (46) getragen ist und einem zweiten Bereich (70), in dem wenigstens eine erste mechanische Schnittstelle (54) und eine zweite mechanische Schnittstelle (54) zum Anbinden des Schaltungsträgers (48) an einen Halter (56) angeordnet ist, und
- ein zwischen dem ersten Bereich (68) und dem zweiten Bereich (70) angeordnetes Schallwiderstandselement (66), das eingerichtet ist, über die erste mechanische Schnittstelle (54) eintretenden Körperschall (64) zur zweiten mechanischen Schnittstelle (54) zu leiten, **dadurch gekennzeichnet, dass** der Schaltungsträger (48) als Leadframe (48) und das Schallwiderstandselement (66) als Schlitz (66) in dem Leadframe (48) ausgebildet sind, und der Sensor ein mechanisches Entkopplungselement (51, 74) umfasst, das den ersten Bereich (68) des Schaltungsträgers (48), die Sensorschaltung (48) und wenigstens teilweise das Schallwiderstandselement (66) einhüllt, wobei das mechanische Entkopplungselement (51, 74) eine Schallentkopplungsfolie (74) umfasst, auf der der erste Bereich (68) des Schaltungsträgers (48) getragen ist.

2. Sensor (14) nach Anspruch 1, wobei der Schlitz (66) um den ersten Bereich (68) umlaufend ausgebildet und der zweite Bereich (70) mit dem ersten Bereich (68) über wenigstens einen Steg (72) verbunden sind.

3. Sensor (14) nach einem der vorhergehenden Ansprüche, wobei das mechanische Entkopplungselement (51, 74) eine Globetop-Masse (51) umfasst.

4. Sensor (14) nach Anspruch 3, wobei der erste Bereich (68) des Schaltungsträgers (48) zwischen der Globetop-Masse (51) und der Schallentkopplungsfolie (74) aufgenommen ist.

5. Sensor (14) nach einem der vorstehenden Ansprüche, wobei an wenigstens eine der beiden mechanischen Schnittstellen (52) ein elektrisches Bezugspotential (82) angelegt ist.

6. Sensor (14) nach einem der vorstehenden Ansprüche, umfassend ein Entkopplungsbauteil (74), auf dem wenigstens ein Teil (30, 36) der Sensorschaltung (46) getragen ist.

7. Sensor (14) nach Anspruch 6, wobei das Entkopplungsbauteil (74) die Schallentkopplungsfolie (74) ist.

8. Sensor (14) nach einem der vorstehenden Ansprüche umfassend eine die Sensorschaltung (46), den ersten Bereich (68) des Schaltungsträgers (48) und wenigstens einen Teil des zweiten Bereichs (70) des Schaltungsträgers (68) einhausende Schutzmasse (52).

## Claims

1. Sensor (14) for sensing a physical transmitter field (32, 38) which is dependent on a physical variable (16) to be measured, comprising:
- a sensor circuit (46) for sensing the transmitter field (32, 38) and for outputting a sensor signal (26, 28) which is dependent on the transmitter field (32, 38),
- a circuit carrier (48) having a first region (68) in which at least part (34) of the sensor circuit (46) is supported, and a second region (70) in which at least a first mechanical interface (54) and a second mechanical interface (54) for connecting the circuit carrier (48) to a retainer (56) are arranged, and
- a noise-resistance element (66) which is arranged between the first region (68) and the second region (70) and is configured to conduct structure-borne noise (64) entering via the first mechanical interface (54) to the second mechanical interface (54),
**characterized in that** the circuit carrier (48) is embodied as a leadframe (48), and the noise-resistance element (66) is embodied as a slit (66) in the leadframe (48), and the sensor comprises a mechanical decoupling element (51, 74) which encapsulates the first region (68) of the circuit carrier (48), the sensor circuit (48) and at least partially the noise-resistance element (66), wherein the mechanical decoupling element (51, 74) comprises a noise-decoupling film (74) on which the first region (68) of the circuit carrier (48) is supported.

2. Sensor (14) according to Claim 1, wherein the slit (66) is designed to run around the first region (68), and the second region (70) is connected to the first region (68) via at least one web (72).

3. Sensor (14) according to either of the preceding claims, wherein the mechanical decoupling element (51, 74) comprises a globe top mass (51).

4. Sensor (14) according to Claim 3, wherein the first region (68) of the circuit carrier (48) is accommodated between the globe top mass (51) and the noise-decoupling film (74).

5. Sensor (14) according to one of the preceding claims, wherein an electrical reference potential (82) is applied to at least one of the two mechanical interfaces (52).

6. Sensor (14) according to one of the preceding claims, comprising a decoupling component (74) on which at least part (30, 36) of the sensor circuit (46) is supported.

7. Sensor (14) according to Claim 6, wherein the decoupling component (74) is the noise-decoupling film (74).

8. Sensor (14) according to one of the preceding claims, comprising a protective mass (52) which encloses the sensor circuit (46), the first region (68) of the circuit carrier (48) and at least part of the second region (70) of the circuit carrier (68) .

## Revendications

1. Capteur (14) pour détecter un champ transmetteur (32, 38) physique dépendant d'une grandeur physique (16) à mesurer, comprenant :
- un circuit capteur (46) destiné à détecter le champ transmetteur (32, 38) et destiné à délivrer un signal de capteur (26, 28) dépendant du champ transmetteur (32, 38),
- un porte-circuit (48) ayant une première zone (68) dans laquelle est portée au moins une partie (34) du circuit capteur (46) et une deuxième zone (70) dans laquelle sont disposées au moins une première interface mécanique (54) et une deuxième interface mécanique (54) servant à attacher le porte-circuit (48) un élément de maintien (56), et
- un élément de résistance acoustique (66) disposé entre la première zone (68) et la deuxième zone (70), lequel est conçu pour guider vers la deuxième interface mécanique (54) un bruit de structure (64) qui pénètre par le biais de la première interface mécanique (54), **caractérisé en ce que**
le porte-circuit (48) est réalisé sous la forme d'une grille de connexion (48) et l'élément de résistance acoustique (66) sous la forme d'une fente (66) dans la grille de connexion (48), et
le capteur comporte un élément de découplage mécanique (51, 74) qui enveloppe la première zone (68) du porte-circuit (48), le circuit capteur (46) et au moins une partie de l'élément de résistance acoustique (66), l'élément de découplage mécanique (51, 74) comportant un film de découplage acoustique (74) sur lequel est supportée la première zone (68) du porte-circuit (48).

2. Capteur (14) selon la revendication 1, la fente (66) étant configurée périphérique autour de la première zone (68) et la deuxième zone (70) étant reliée à la première zone (68) par le biais d'au moins un élément jointif (72).

3. Capteur (14) selon l'une des revendications précédentes, l'élément de découplage mécanique (51, 74) comportant une masse à sommet en globe (51).

4. Capteur (14) selon la revendication 3, la première zone (68) du porte-circuit (48) étant accueillie entre la masse à sommet en globe (51) et le film de découplage acoustique (74).

5. Capteur (14) selon l'une des revendications précédentes, un potentiel de référence électrique (82) étant appliqué à au moins l'une des deux interfaces mécaniques (52).

6. Capteur (14) selon l'une des revendications précédentes, comprenant un composant de découplage (74) sur lequel est supportée au moins une partie (30, 36) du circuit capteur (46).

7. Capteur (14) selon la revendication 6, le composant de découplage (74) étant le film de découplage acoustique (74).

8. Capteur (14) selon l'une des revendications précédentes, comprenant une masse de protection (52) qui accueille le circuit capteur (46), la première zone (68) du porte-circuit (48) et au moins une partie de la deuxième zone (70) du porte-circuit (68).
